# DEMANDE DE BREVET EUROPEEN

(11) **EP 2 246 885 A1**
(43) Date de publication de la demande: **03.11.2010**
(21) Numéro de dépôt: 10153639.9
(22) Date de dépôt: 15.02.2010
(51) Int. Cl.: H01L 27/02

(54) **Structure de protection d'un circuit intégré contre des décharges électrostatiques**

(30) Priorité: 27.04.2009 FR 0952751
(71) Demandeur: STmicroelectronics SA, 92120 Montrouge (FR)
(72) Inventeur: Galy, Philippe, 38660, LE TOUVET (FR); Entringer, Christophe, 38190, BRIGNOUD (FR); Bourgeat, Johan, 38100, GRENOBLE (FR)
(74) Mandataire: de Beaumont, Michel

(57) **Abrégé**

L'invention concerne une structure de protection d'un circuit intégré contre des décharges électrostatiques, comprenant un ensemble de cellules identiques (30a, 30b, 30c), dont chacune est reliée à une borne constituant un plot (3) du circuit, un premier rail d'alimentation (5), ou un second rail d'alimentation (7), les cellules formant entre deux quelconques desdites bornes un assemblage de quatre couches alternées de types de conductivité distincts (41-33-37-39).

## Description

### Domaine de l'invention

La présente invention concerne des structures de protection des circuits intégrés contre des décharges électrostatiques.

### Exposé de l'art antérieur

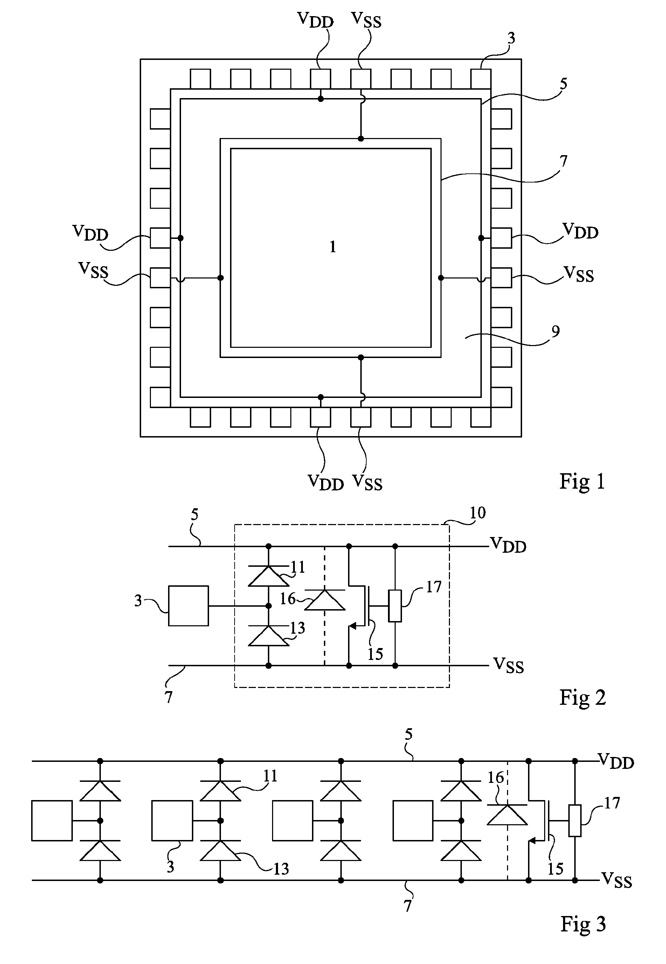

La figure 1 est une vue de dessus schématique d'une puce de circuit intégré. Le circuit intégré comprend une partie centrale 1 reliée à un ensemble de plots métalliques 3 disposés à la périphérie de la puce et destinés à assurer des connexions vers l'extérieur. La partie centrale 1 comprend l'ensemble des composants permettant au circuit intégré de remplir des fonctions souhaitées. Certains des plots 3 sont destinés à recevoir des potentiels d'alimentation haut (V_{DD}) et bas (V_{SS}). Des rails d'alimentation haute 5 et basse 7 sont généralement prévus tout autour du circuit. Les autres plots 3 sont notamment destinés à recevoir et/ou à fournir des signaux d'entrée-sortie. L'ensemble du circuit est recouvert d'une couche isolante ne laissant accessible que des bornes reliées aux plots 3, et est éventuellement mis dans un boîtier comprenant des cosses aux plots 3 ou des billes liées à ces plots.

Un tel circuit reçoit et/ou fournit généralement des signaux à faible niveau de tension (par exemple 0,6 à 3 V) et à faible intensité de courant (par exemple 1 µA à 10 mA), et est susceptible d'être endommagé lorsque des surtensions ou des surintensités surviennent entre des plots du boîtier. Des surtensions peuvent survenir, pendant la phase de fabrication ou d'assemblage, avant le montage du circuit dans un dispositif (par exemple sur une carte de circuit imprimé), lors de décharges électrostatiques liées à la manipulation des circuits par des outils ou à la main. Ces surtensions peuvent atteindre plusieurs milliers de volts et détruire des éléments du circuit.

On prévoit donc d'associer à chaque plot 3 une structure de protection qui occupe généralement une couronne 9 disposée entre les plots 3 et la partie centrale 1 de la puce. La structure de protection doit être capable d'évacuer rapidement des courants importants, susceptibles d'apparaître lorsqu'une décharge électrostatique survient entre deux plots ou deux bornes du boîtier.

La figure 2 représente un exemple de structure de protection 10, associée à un plot d'entrée-sortie 3 d'un circuit intégré. Une diode 11 est connectée en direct entre le plot 3 et le rail d'alimentation haute 5. Une diode 13 est connectée en inverse entre le plot 3 et le rail d'alimentation basse 7. Un transistor MOS 15, utilisé comme interrupteur, est connecté entre les rails 5 et 7 d'alimentation haute et basse. Un circuit 17 de détection de surtension, connecté parallèlement au transistor MOS 15, fournit un signal de déclenchement à ce transistor. Le circuit 17 de détection de surtension pourra par exemple être un détecteur de front comprenant une résistance en série avec un condensateur, le noeud de connexion entre la résistance et le condensateur changeant d'état en cas de surtension brutale. Le transistor MOS 15 comporte notamment une diode parasite 16 connectée en direct entre le rail 7 et le rail 5.

On indiquera ci-après le fonctionnement de la structure de protection en cas de surtension survenant sur un plot d'entrée-sortie (on parlera simplement de "plots") ou sur un plot relié à un rail d'alimentation (on parlera simplement de "rail").

En fonctionnement normal, lorsque la puce est alimentée, les signaux sur les plots 3 et les rails 5 et 7 sont tels que les diodes 11 et 13 ne laissent pas passer de courant et le circuit de détection 17 rend le transistor MOS 15 non passant.

En cas de surtension positive entre les rails 5 et 7 d'alimentation haute et basse, le circuit 17 rend le transistor 15 passant, ce qui permet l'évacuation de la surtension.

En cas de surtension négative entre les rails 5 et 7 d'alimentation haute et basse, la diode 16 devient passante et la surtension est évacuée.

En cas de surtension positive entre un plot 3 et le rail d'alimentation haute 5, la diode 11 devient passante et la surtension est évacuée.

En cas de surtension négative entre un plot 3 et le rail 5, le circuit 17 rend le transistor 15 passant, et la surtension est évacuée par le transistor 15 et la diode 13.

En cas de surtension positive entre un plot 3 et le rail d'alimentation basse 7, la diode 11 devient passante et la surtension positive est reportée sur le rail d'alimentation haute 5, ce qui correspond au cas traité ci-dessus d'une surtension positive entre les rails 5 et 7.

En cas de surtension négative entre un plot 3 et le rail d'alimentation basse 7, la diode 13 devient passante et la surtension est évacuée.

En cas de surtension positive ou négative entre deux plots 3, les diodes 11 ou 13 associées aux plots concernés deviennent passantes, et la surtension est reportée sur les rails d'alimentation haute 5 et basse 7. Cela correspond à l'un des cas de surtension traités ci-dessus.

Un inconvénient d'une telle structure de protection réside dans le fait que, pour pouvoir évacuer les courants induits par des décharges électrostatiques, les diodes 11 et 13 et le transistor 15 doivent avoir une surface importante (typiquement, un périmètre de jonction de 200 µm par diode et une largeur de grille de 4000 µm par transistor). Il en résulte que la couronne 9 (figure 1) occupe une surface de silicium importante, au détriment de la partie centrale 1 de la puce. En outre, du fait de sa grande taille, le transistor MOS 15 à l'état bloqué est traversé par des courants de fuite significatifs, ce qui augmente la consommation du circuit.

Par ailleurs, les diodes 11 et 13 et le transistor 15 sont des composants distincts, ce qui rend la fabrication de la couronne 9 complexe. Les composants distincts doivent en outre être isolés les uns des autres, ce qui augmente la surface totale de silicium d'un circuit intégré.

Une telle structure présente aussi l'inconvénient de réagir différemment selon le type de surtension engendré par une décharge électrostatique. En effet, les chemins d'évacuation des courants diffèrent selon les caractéristiques des surtensions appliquées aux bornes du circuit.

En outre, avec une telle structure de protection, l'amplitude des signaux d'entrée-sortie est limitée à une plage de valeurs comprise entre le potentiel d'alimentation basse V_{SS} moins la tension de seuil de la diode 13 et le potentiel d'alimentation haute V_{DD} plus la tension de seuil de la diode 11. En dehors de cette plage de valeurs, les diodes deviennent passantes et le circuit ne peut plus fonctionner correctement.

La figure 3 illustre un autre exemple de structure de protection de plusieurs plots d'un circuit intégré. Au lieu d'utiliser un transistor MOS de protection 15 pour chaque plot 3 du circuit, comme cela a été décrit ci-dessus en relation avec la figure 2, on peut utiliser un unique transistor MOS 15 pour évacuer les surtensions liées à plusieurs plots 3 du circuit. On pourra par exemple utiliser un transistor MOS pour trois à dix plots 3 du circuit. Seules les diodes 11 et 13 sont reproduites à chaque plot 3. Un inconvénient de cette structure est que, si une décharge électrostatique se produit entre deux plots éloignés du transistor 15 et du circuit de détection 17, le chemin d'évacuation de la surtension est relativement long. Le courant induit par la décharge pouvant être très important, la résistivité des rails entraîne l'apparition d'une tension significative entre les plots. La surtension est donc mal évacuée et risque d'endommager le circuit.

### Résumé

Ainsi, un objet d'un mode de réalisation de la présente invention est de proposer une structure de protection des circuits intégrés contre des décharges électrostatiques palliant tous ou au moins certains des inconvénients cités ci-dessus des solutions de l'art antérieur.

Un objet d'un mode de réalisation de la présente invention est de proposer une telle structure occupant une faible surface de silicium.

Un objet d'un mode de réalisation de la présente invention est de proposer une telle structure ne limitant pas la plage de valeurs dans laquelle l'amplitude des signaux d'entrée-sortie doit être comprise.

Un objet d'un mode de réalisation de la présente invention est de proposer une telle structure ne perturbant pas le bon fonctionnement du circuit lorsque ce dernier est alimenté.

En particulier, un objet d'un mode de réalisation de la présente invention est de proposer une telle structure ne présentant pas ou peu de courants de fuite lorsque le circuit est alimenté.

Un autre objet d'un mode de réalisation de la présente invention est de proposer une telle structure facile à réaliser.

Ainsi, un mode de réalisation de la présente invention prévoit une structure de protection d'un circuit intégré contre des décharges électrostatiques, comprenant un ensemble de cellules identiques, dont chacune est reliée à une borne constituant un plot du circuit, un premier rail d'alimentation, ou un second rail d'alimentation, les cellules formant entre deux quelconques desdites bornes un assemblage de quatre couches alternées de types de conductivité distincts.

Selon un mode de réalisation de la présente invention, les cellules sont formées dans une couche d'un premier type de conductivité d'un premier niveau de dopage, chaque cellule comprenant un caisson d'un second type de conductivité d'un deuxième niveau de dopage, contenant du côté de sa surface des régions voisines de niveaux de dopage supérieurs aux premier et deuxième niveaux et de types de conductivité opposés, en contact avec une métallisation reliée à ladite borne.

Selon un mode de réalisation de la présente invention, des régions de contact du premier type de conductivité et d'un niveau de dopage supérieur au premier niveau sont disposées du côté de la face supérieure de ladite couche et sont adaptées à recevoir un signal de déclenchement.

Selon un mode de réalisation de la présente invention, les régions de contact sont reliées à la sortie d'un circuit de déclenchement adapté à fournir un signal de commande en cas de surtension entre deux quelconques desdites bornes.

Selon un mode de réalisation de la présente invention, ledit circuit de déclenchement comporte : un détecteur de surtension adapté à fournir un signal de sortie haut quand le circuit intégré est alimenté ; un premier inverseur dont l'entrée est reliée à la sortie du détecteur ; un second inverseur dont l'entrée est reliée à la sortie du premier inverseur, la sortie du second inverseur constituant la sortie du circuit de déclenchement ; au moins une première diode connectée en direct entre la sortie du second inverseur et le premier rail d'alimentation ; et un thyristor connecté en direct entre la sortie du second inverseur et un plot du circuit, les gâchettes d'anode et de cathode du thyristor étant respectivement reliées à la sortie du second inverseur et au second rail d'alimentation.

Selon un mode de réalisation de la présente invention : ledit détecteur est constitué d'un premier transistor MOS à canal P et d'un premier transistor MOS à canal N, la source et le drain du premier transistor à canal P étant respectivement reliés au premier rail d'alimentation et à la grille du premier transistor à canal N, la grille du premier transistor à canal P et la source et le drain du premier transistor à canal N étant reliés au second rail d'alimentation ; le premier inverseur est constitué d'un second transistor MOS à canal P et d'un second transistor MOS à canal N et est alimenté par les premier et second rails d'alimentation ; le second inverseur est constitué d'un troisième transistor MOS à canal P et d'un troisième transistor MOS à canal N et est alimenté par les premier et second rails d'alimentation.

Selon un mode de réalisation de la présente invention, chaque couple de cellules forme un triac entre deux desdites bornes.

Selon un mode de réalisation de la présente invention, les cellules sont disposées matriciellement dans une couronne située entre les plots et la partie centrale du circuit.

Selon un mode de réalisation de la présente invention : la matrice de cellules a des rangées parallèles à la ligne de plots et des colonnes orthogonales à cette ligne ; la portion de couronne délimitée par deux plots successifs contient au moins trois colonnes ; et toutes les cellules d'une diagonale sont reliées à une même borne.

Selon un mode de réalisation de la présente invention, les diagonales de cellules interconnectées consécutives sont reliées à des bornes constituant dans l'ordre qui suit : le premier rail d'alimentation ; un plot du circuit ; le second rail d'alimentation ; et un plot du circuit.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue de dessus schématique d'une puce de circuit intégré ;
la figure 2, précédemment décrite, représente un exemple de structure de protection contre les surtensions associée à un plot d'un circuit intégré ;
la figure 3, précédemment décrite, illustre un exemple de structure de protection de plusieurs plots d'un circuit intégré ;
la figure 4 représente un exemple de structure de protection associée à un plot d'un circuit intégré selon un mode de réalisation de l'invention ;
la figure 5 est une vue en coupe d'une structure de protection selon un mode de réalisation de l'invention ;
la figure 6 est une vue de dessus d'une portion d'une structure de protection selon un mode de réalisation de l'invention ;
la figure 7 est une vue de dessus simplifiée d'une portion d'une structure de protection contre les surtensions selon un mode de réalisation de l'invention ;
la figure 8 est un exemple de réalisation d'un circuit de déclenchement adapté à fournir un signal à la structure de protection présentée en figure 4, en cas de surtension ; et
la figure 9 illustre l'explication de l'élimination d'une surtension entre plots d'entrée-sortie.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

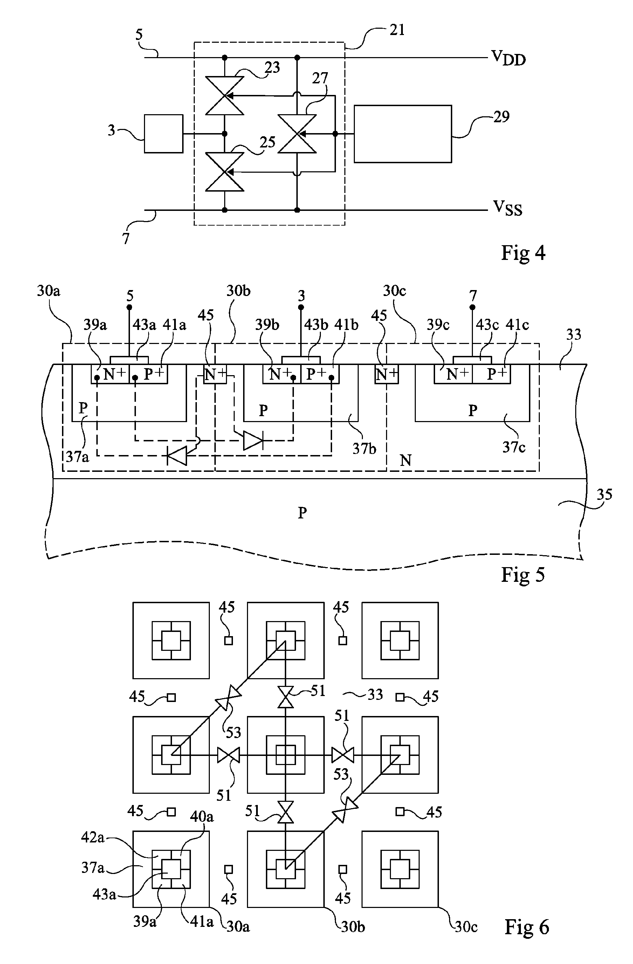

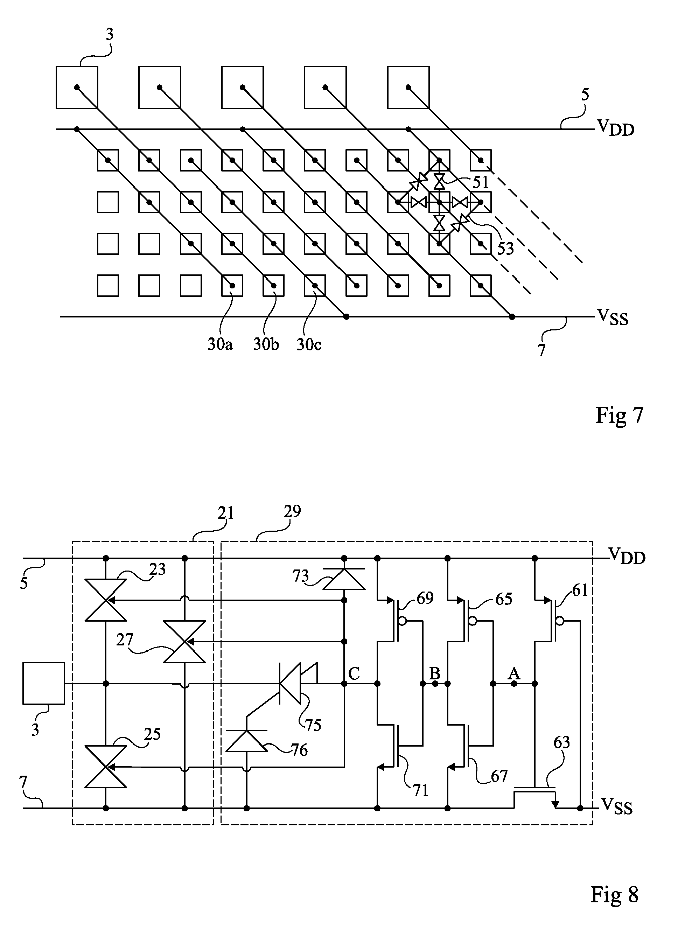

La figure 4 représente un exemple de structure de protection 21 associée à un plot d'entrée-sortie 3 d'un circuit intégré. Un premier triac 23 est connecté entre le plot 3 et le rail d'alimentation haute 5. Un deuxième triac 25 est connecté entre le plot 3 et le rail d'alimentation basse 7. Un troisième triac 27 est connecté entre les rails 5 et 7. Un circuit de détection 29, apte à détecter des surtensions éventuelles entre deux plots quelconques du circuit, commande de façon simultanée les triacs 23, 25, et 27. Un exemple de réalisation du circuit 29 sera exposé ci-après en relation avec la figure 8.

En fonctionnement normal, c'est-à-dire lorsque la puce est alimentée, le circuit 29 bloque les triacs 23, 25, et 27.

En cas de surtension positive ou négative entre les rails 5 et 7 d'alimentation haute et basse, le circuit 29 valide les triacs, et la surtension est évacuée, principalement par le triac 27.

En cas de surtension positive ou négative entre un plot 3 et le rail d'alimentation haute 5, le circuit 29 valide les triacs, et la surtension est évacuée, principalement par le triac 23.

En cas de surtension positive ou négative entre un plot 3 et le rail d'alimentation basse 7, le circuit 29 valide les triacs, et la surtension est évacuée, principalement par le triac 25.

En cas de surtension positive ou négative entre deux plots d'entrée-sortie, les triacs associés aux plots concernés sont validés, ce qui permet à la surtension d'être évacuée.

La structure de protection 21 permet donc d'évacuer tous les types de surtension pouvant survenir entre plots et/ou rails du circuit par suite d'une décharge électrostatique.

Selon un aspect de la présente invention, les divers triacs sont constitués à partir d'un ensemble de cellules élémentaires identiques les unes aux autres.

La figure 5 est une vue en coupe de cellules élémentaires 30a, 30b, 30c contribuant à la réalisation de la structure de protection 21 décrite en relation avec la figure 4. Une couche faiblement dopée de type N 33 est réalisée dans un substrat de silicium faiblement dopé de type P 35. Des cellules élémentaires 30a, 30b, 30c sont réalisées dans la partie supérieure de la couche N 33. Chaque cellule élémentaire comporte, à la surface d'un caisson faiblement dopé de type P 37a, 37b, 37c des régions voisines d'un niveau de dopage élevé et de types de conductivité distincts. Ce niveau de dopage est notamment supérieur aux niveaux de dopage du substrat 35, de la couche 33, et des caissons 37a, 37b, 37c. Des régions 39a, 39b, 39c de type N et des régions 41a, 41b, 41c de type P sont représentées sur la figure 5. Une métallisation 43a, 43b, 43c forme un contact ohmique avec chacun des couples de régions 39a et 41a, 39b et 41b, 39c et 41c. Les métallisations 43a, 43b, et 43c sont respectivement reliées au rail d'alimentation haute 5, à un plot 3 du circuit, et au rail d'alimentation basse 7. La couche N 33 comporte en outre des régions de contact 45 destinées à être reliées à la sortie d'un dispositif de détection des surtensions. Les régions de contact 45 sont des régions de type N à fort niveau de dopage.

Chaque couple de cellules constitue entre deux métallisations un triac constitué de deux thyristors en antiparallèle. Par exemple, entre les métallisations 43a et 43b, on trouve un premier thyristor PNPN correspondant aux régions 41a-33-37b-39b, et un second thyristor PNPN correspondant aux régions 41b-33-37a-39a. Ces deux thyristors ont une gâchette d'anode commune constituée par la région de contact 45.

La figure 6 est une vue de dessus d'un ensemble de cellules élémentaires 30a, 30b, 30c réalisées dans une couche N 33 tel que décrit ci-dessus (figure 5). Dans le mode de réalisation illustré chaque cellule comprend, à la surface d'un caisson faiblement dopé de type P 37a, en diagonale, deux régions fortement dopées de type N 39a et 40a et deux régions fortement dopées de type P 41a et 42a. L'invention ne se restreint pas à ce seul cas particulier. En outre, l'invention ne se restreint pas au seul cas illustré par la figure 6 dans lequel les régions 39a, 40a, 41a, et 42a sont en contact direct les unes avec les autres. En effet, les régions fortement dopées de type N et P peuvent être disjointes. Une métallisation 43a forme un contact ohmique avec les régions 39a, 40a, 41a et 42a.

Si les cellules sont disposées matriciellement (comme représenté), des triacs identiques 51 sont formés par les couples de cellules voisines appartenant à des lignes ou colonnes successives de la matrice. Des triacs identiques 53 sont formés par les couples de cellules voisines appartenant à des diagonales successives de la matrice. On remarquera que la distance entre électrodes principales des triacs 53 est supérieure par un facteur √2 à la distance entre électrodes principales des triacs 51. La capacité d'un triac à évacuer des courants importants étant liée à la distance entre ses électrodes, les triacs 51 sont plus efficaces que les triacs 53. Des régions de contact 45, destinées à être reliées à la sortie d'un dispositif de détection des surtensions, constituent la gâchette de déclenchement des triacs. Les régions de contact 45 ont été représentées sous forme d'îlots ponctuels, cependant, l'invention ne se retreint pas à ce seul cas particulier. Les régions de contact 45 peuvent être réalisées sous forme de lignes, d'un quadrillage entourant les cellules élémentaires, ou de toute autre forme géométrique.

Pour réaliser la structure de protection 21 recherchée telle que décrite ci-dessus en relation avec la figure 4, il est prévu un ensemble de cellules élémentaires 30a, 30b, 30c disposées matriciellement dans la couche N 33. L'agencement de la matrice et les connexions des cellules aux plots et rails du circuit seront expliqués plus en détail ci-après en relation avec la figure 7.

La figure 7 est une vue de dessus simplifiée d'une portion de la structure de protection décrite ci-dessus en relation avec les figures 4 à 6. Les cellules élémentaires 30a, 30b, 30c, représentées simplement sous forme d'un carré avec un point central correspondant à leur métallisation de connexion, sont agencées sous forme d'une matrice ayant des rangées parallèles à la ligne de plots 3 et des colonnes orthogonales à cette ligne. La matrice occupe une couronne (correspondant à la couronne 9 de la figure 1) entre les plots 3 et la partie centrale du circuit. Les cellules formant une diagonale de la matrice sont reliées à un même plot d'entrée-sortie 3 ou rail d'alimentation 5 ou 7. Les diagonales consécutives sont reliées selon la séquence suivante au rail 5, à un plot 3, au rail 7, et à un plot 3. Des triacs 53 sont ainsi formés entre les rails 5 et 7 d'alimentation, et des triacs 51, plus efficaces que les triacs 53, sont formés entre chaque plot 3 et les rails 5 et 7. Un avantage de la séquence de connexion décrite ci-dessus réside dans le fait que les triacs 53 de moindre efficacité sont formés un grand nombre de fois dans la structure, entre les rails 5 et 7. Ce grand nombre compense leur efficacité réduite par rapport aux triacs 51. Les régions de contact 45 (figure 6) formant la gâchette des triacs, permettent de valider simultanément tous les triacs de la structure en cas de surtension brutale, réalisant ainsi la fonction de protection souhaitée telle que décrite ci-dessus en relation avec la figure 4.

La figure 8 représente un exemple de circuit de détection de surtension entre deux plots ou rails quelconques du circuit, et de déclenchement des triacs de la structure de protection.

La figure 8 reprend et détaille le circuit de la figure 4. La structure de protection 21 associée à un plot d'entrée-sortie 3 du circuit est constituée de trois triacs 23, 25, et 27, reliés entre le plot 3 et les rails 5 et 7 d'alimentation haute (V_{DD}) et basse (V_{SS}) de la façon décrite en relation avec la figure 4. Chaque triac est constitué de deux thyristors en antiparallèle ayant une gâchette d'anode commune.

Le circuit de détection et de déclenchement 29 comprend un détecteur de front dynamique incluant un transistor MOS à canal P 61 et un transistor MOS à canal N 63. La source du transistor 61 est reliée au rail haut 5. Le drain du transistor 61 est relié à la grille du transistor 63 en un noeud A. La source et le drain du transistor 63 et la grille du transistor 61 sont reliés au rail bas 7. Ainsi, les transistors 61 et 63 se comportent respectivement comme une résistance et un condensateur.

Un premier inverseur est constitué d'un transistor MOS à canal P 65 et d'un transistor MOS à canal N 67. Les sources des transistors 65 et 67 sont respectivement reliées aux rails d'alimentation 5 et 7. Les grilles des transistors 65 et 67 sont reliées au noeud A et constituent l'entrée de l'inverseur. Les drains des transistors 65 et 67, reliés entre eux en un noeud B, constituent la sortie de l'inverseur.

Un second inverseur est constitué d'un transistor MOS à canal P 69 et d'un transistor MOS à canal N 71. Les sources des transistors 69 et 71 sont respectivement reliées aux rails d'alimentation 5 et 7. Les grilles des transistors 69 et 71 sont reliées au noeud B de sortie du premier inverseur et constituent l'entrée du second inverseur. Les drains des transistors 69 et 71, reliés entre eux en un noeud C, constituent la sortie du second inverseur.

La sortie C du second inverseur est reliée aux gâchettes des triacs 23, 25 et 27. Une diode 73 est connectée en direct entre le noeud C et le rail haut 5. Un thyristor 75 est connecté en direct entre le noeud C et le plot 3. Ce thyristor comporte une gâchette d'anode (région de type N dans laquelle est formée la région d'anode) et une gâchette de cathode (région de type P dans laquelle est formée la région de cathode). L'anode et la gâchette d'anode du thyristor 75 sont reliées entre elles. Ainsi, lorsqu'il existe une différence de potentiel positive entre l'anode et la cathode du thyristor 75, ce dernier est rendu passant si un courant de déclenchement circule entre sa gâchette de cathode et sa cathode. En outre, si aucun courant de déclenchement ne circule dans la gâchette de cathode mais que la différence de potentiel anode-cathode est supérieure à un seuil, le thyristor 75 entre en avalanche. Le seuil de conduction en avalanche dépend notamment des niveaux de dopage des régions de type N et P constituant la diode inverse du thyristor et sera couramment de l'ordre de 6 à 10 V. Une diode 76 peut être connectée en direct entre le rail bas 7 et la gâchette de cathode du thyristor 75.

En fonctionnement normal, le rail 5 est relié à une borne d'alimentation haute de potentiel positif (V_{DD}) et le rail 7 est relié à une borne d'alimentation de potentiel négatif (V_{SS}). Le noeud A de sortie du détecteur de front est à un état haut et le noeud C de sortie du second inverseur est à un état haut correspondant sensiblement au potentiel positif V_{DD} du rail 5. Le noeud C étant relié à la gâchette d'anode du thyristor constitutif du triac 27, connecté en direct entre le rail positif 5 et le rail négatif 7, il ne peut pas circuler de courant entre l'anode et la gâchette d'anode de ce thyristor. Le triac 27, et de façon similaire, les triacs 23 et 25, restent donc bloqués.

Comme on l'a vu précédemment, la structure de protection 21 permet que la tension sur un plot d'entrée-sortie puisse varier en dehors de la plage V_{SS}, V_{DD}. L'excursion de tension est limitée uniquement par le circuit de détection et de déclenchement. Dans le cas du mode de réalisation particulier de circuit de détection et de déclenchement décrit, cette excursion est limitée par :
- le potentiel d'alimentation basse V_{SS}, moins la tension de seuil de la jonction entre la cathode et la gâchette de cathode du thyristor 75 (moins la tension de seuil de la diode 76 si elle est prévue), et
- le potentiel d'alimentation haute V_{DD}, plus la tension de seuil de la jonction entre l'anode et la gâchette d'anode du thyristor constitutif du triac 23, connecté en direct entre le rail 5 et le plot 3, plus la tension de seuil de la diode 73.

Pour étendre davantage la plage de valeurs dans laquelle peut évoluer l'amplitude des signaux d'entrée-sortie, il suffira d'ajouter des diodes supplémentaires, en série avec les diodes 73 et 76.

Lorsque la puce n'est pas alimentée, le noeud A de sortie du détecteur de front est à un état bas. Les inverseurs n'étant pas alimentés, leurs sorties B et C sont à des états indéterminés.

En cas de surtension positive entre le plot 3 et le rail 7, le thyristor constitutif du triac 25, connecté en direct entre le plot 3 (en ce cas positif) et le rail 7 (en ce cas négatif), est susceptible d'être rendu passant. La jonction PN formée entre l'anode et la gâchette d'anode de ce thyristor tend à devenir passante, de même que la diode 73, et un potentiel positif est reporté sur le rail 5. Ainsi, la surtension fournit une tension d'alimentation aux inverseurs constitués par les transistors 65, 67, 69 et 71. Le noeud A de sortie du détecteur de front étant à un état bas, le noeud B de sortie du premier inverseur passe à un état haut, ce qui rend passant le transistor MOS à canal N 71 du second inverseur. Il circule donc un courant entre le plot 3 et le rail 7, passant par la gâchette du triac 25 et par le transistor 71. Ce courant de gâchette déclenche le triac 25. Le triac 25 est donc rendu passant ce qui permet l'évacuation de la surtension.

En cas de surtension négative entre le plot 3 et le rail 7, le thyristor constitutif du triac 25, connecté en direct entre le rail 7 (en ce cas positif) et le plot 3 (en ce cas négatif), est susceptible d'être rendu passant. La jonction PN formée entre l'anode et la gâchette d'anode de ce thyristor tend à devenir passante. Un potentiel positif est donc reporté sur l'anode C du thyristor 75 dont la cathode est reliée au plot négatif 3. La gâchette de cathode du thyristor 75 étant reliée au rail positif 7, le thyristor 75 devient passant. Il circule donc un courant entre le plot 3 et le rail 7, passant par la gâchette du triac 25 et par le thyristor 75. Ce courant de gâchette déclenche le triac 25. Le triac 25 est donc rendu passant ce qui permet l'évacuation de la surtension.

En cas de surtension positive entre le rail 5 et le plot 3, le thyristor constitutif du triac 23, connecté en direct entre le rail 5 (en ce cas positif) et le plot 3 (en ce cas négatif), est susceptible d'être rendu passant. La jonction PN formée entre l'anode et la gâchette d'anode de ce thyristor tend à devenir passante et un fort potentiel positif est reporté sur l'anode C du thyristor 75 dont la cathode est reliée au plot négatif 3. Le thyristor 75 entre en avalanche et il circule un courant entre le rail 5 et le plot 3, passant par la gâchette du triac 23 et par le thyristor 75. Ce courant de gâchette déclenche le triac 23. Le triac 23 est donc rendu passant ce qui permet l'évacuation de la surtension.

En cas de surtension négative entre le rail 5 et le plot 3, le thyristor constitutif du triac 23, connecté en direct entre le plot 3 (en ce cas positif) et le rail 5 (en ce cas négatif), est susceptible d'être rendu passant. La jonction PN formée entre l'anode et la gâchette d'anode de ce thyristor tend à devenir passante, de même que la diode 73. Il circule donc un courant entre le rail 5 et le plot 3, passant par la gâchette du triac 23 et par la diode 73. Ce courant de gâchette déclenche le triac 23. Le triac 23 est donc rendu passant ce qui permet l'évacuation de la surtension.

En cas de surtension positive entre les rails 5 et 7, le thyristor constitutif du triac 27, connecté en direct entre le rail 5 (en ce cas positif) et le rail 7 (en ce cas négatif), est susceptible d'être rendu passant. La jonction PN formée entre l'anode et la gâchette d'anode de ce thyristor tend à devenir passante et un potentiel positif est reporté sur le noeud C de sortie du second inverseur. En outre, la surtension fournit une tension d'alimentation aux inverseurs constitués par les transistors 65, 67, 69 et 71. Le noeud A de sortie du détecteur de front étant à un état bas, le noeud B de sortie du premier inverseur passe à un état haut, ce qui rend passant le transistor MOS à canal N 71 du second inverseur. Il circule donc un courant entre les rails 5 et 7, passant par la gâchette du triac 27 et par le transistor 71. Ce courant de gâchette déclenche le triac 27. Le triac 27 est donc rendu passant ce qui permet l'évacuation de la surtension.

En cas de surtension négative entre les rails 5 et 7, le thyristor constitutif du triac 27, connecté en direct entre le rail 7 (en ce cas positif) et le rail 5 (en ce cas négatif), est susceptible d'être rendu passant. La jonction PN formée entre l'anode et la gâchette d'anode de ce thyristor tend à devenir passante, de même que la diode 73. Il circule donc un courant entre les rails 7 et 5, passant par la gâchette du triac 27 et par la diode 73. Ce courant de gâchette déclenche le triac 27. Le triac 27 est donc rendu passant ce qui permet l'évacuation de la surtension.

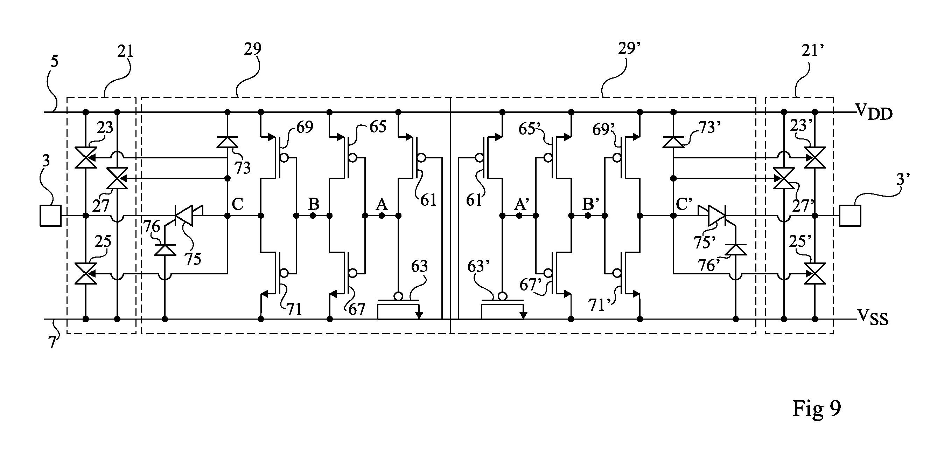

Pour l'explication de l'élimination d'une surtension entre plots, on se référera à la figure 9. A un plot 3' est associé une structure de protection 21' et un circuit de détection et de déclenchement 29' identiques à la structure de protection 21 et au circuit de détection et de déclenchement 29 associés au plot 3. Les éléments associés au plot 3 sont désignés par les mêmes références qu'à la figure 8. Les éléments associés au plot 3' sont désignés par les mêmes numéros que les éléments correspondants associés au plot 3, primés.

En cas de surtension positive entre les plots 3 et 3', les thyristors constitutifs des triacs 23 et 25, connectés en direct entre le plot 3 et les rails 5 et 7, et les thyristors constitutifs des triacs 23' et 25', connectés en inverse entre le plot 3' et les rails 5 et 7, sont susceptibles d'être rendus passants. Les jonctions PN formées entre les anodes et gâchettes d'anodes respectives des thyristors susmentionnés, constitutifs des triacs 23 et 25, tendent à devenir passantes. Un potentiel positif est donc reporté sur l'anode C de la diode 73 qui devient passante. Ainsi, la surtension fournit une tension d'alimentation aux inverseurs constitués par les transistors 65, 67, 69 et 71. Le noeud A de sortie du détecteur de front étant à un état bas, le noeud B de sortie du premier inverseur passe à un état haut, ce qui rend passant le transistor MOS à canal N 71 du second inverseur. Un potentiel positif est donc reporté sur le rail 7. Des potentiels positifs étant reportés sur les rails 5 et 7, les jonctions PN formées entre les anodes et gâchettes d'anode respectives des thyristors susmentionnés, constitutifs des triacs 23' et 25', tendent à devenir passantes. Un potentiel positif est donc reporté sur l'anode C' du thyristor 75' dont la cathode est reliée au plot négatif 3'. En outre, un potentiel positif est reporté, via le rail 7 et la diode 76' (si elle est prévue), sur la gâchette de cathode du thyristor 75'. Le thyristor 75' est donc rendu passant. Il circule donc un courant entre le plot positif 3 et le plot négatif 3', passant par les gâchettes des triacs 23, 25, 23' et 25', la diode 73, le transistor 71 et le thyristor 75'. Ce courant de gâchette déclenche les triacs 23, 25, 23' et 25'. Les triacs 23, 25, 23' et 25' sont donc rendus passants, ce qui permet l'évacuation de la surtension.

Le circuit de détection présenté permet donc de déclencher au moins un triac de la structure de protection quel que soit le type de surtension survenant entre deux bornes du circuit intégré.

Selon un avantage de l'invention, la cellule élémentaire décrite ci-dessus (figures 5 à 7) est l'unique composant nécessaire à la réalisation de la structure de protection contre les surtensions (figure 4). Les cellules de la structure sont réalisées dans la même couche de type N 33 (figure 5) et ne nécessitent pas d'être isolées les unes des autres. Ainsi, la surface de silicium utile à l'évacuation des surtensions est optimisée par rapport aux structures de l'art antérieur comportant trois composants distincts (figures 2 et 3). En outre, la structure de protection proposée est plus facile à réaliser que des structures traditionnelles.

Selon un autre avantage de l'invention, la structure de protection proposée fournit des chemins d'évacuation des surtensions symétriques, quelle que soit la polarité des décharges électrostatiques appliquées aux bornes du circuit.

Selon un autre avantage de l'invention, la structure de protection proposée ne perturbe pas le fonctionnement normal du circuit. En effet, lorsque le circuit est alimenté, les triacs présentent des courants de fuite très faibles (quelques pA/mm), au contraire des solutions de l'art antérieur comprenant des transistors MOS (figures 2 et 3).

Selon un autre avantage de l'invention, la structure de protection proposée ne limite pas l'excursion de tension des signaux pouvant être appliqués aux plots d'entrée-sortie du circuit intégré. En effet, les triacs ne sont rendus passants que s'ils sont validés par le circuit de détection des surtensions. Ainsi, des signaux d'amplitude supérieure au potentiel d'alimentation haute V_{DD} ou inférieure au potentiel d'alimentation basse V_{SS} peuvent être appliqués aux plots d'entrée-sortie du circuit. Cette excursion de tension est limitée uniquement par le circuit de détection et de déclenchement. Comme on l'a indiqué, ce circuit de détection et de déclenchement pourra être adapté pour augmenter l'excursion de tension.

Des modes de réalisation particuliers de la présente invention ont été décrits. Diverses variantes et modifications apparaîtront à l'homme de l'art. En particulier, la couronne de protection peut être réalisée dans un substrat de type N au lieu d'un substrat de type P, tous les types de conductivité décrits précédemment étant alors inversés. En outre, l'invention ne se restreint pas aux agencements de cellules représentés et décrits ci-dessus (figures 5 à 7). L'homme de l'art saura mettre en oeuvre le fonctionnement recherché, et notamment la formation de triacs entre les plots et rails du circuit, quel que soit l'agencement et le nombre des cellules élémentaires. On pourra par exemple associer des matrices distinctes de cellules élémentaires à chaque plot du circuit. On a indiqué que tous les éléments de protection entre les plots sont des triacs. On pourra aussi prévoir, si cela est compatible avec le procédé de fabrication du circuit intégré, que certains au moins de ces triacs ne comportent pas de gâchette et sont susceptibles de fonctionner en retournement, constituant alors des diacs (ou double diode de Shockley). Par ailleurs, on a mentionné dans la description d'un mode de réalisation de l'invention des tensions positives et des tensions négatives, il est bien sur entendu que le terme "positif" désigne des tensions supérieures aux tensions désignées par le terme "négatif" et inversement. Bien souvent, la tension "négative" sera la masse. En outre, on a décrit ci-dessus en relation avec la figure 8 un mode de réalisation d'un circuit de détection de surtension et de déclenchement des triacs de protection. L'invention ne se restreint pas à ce seul cas particulier. L'homme de l'art saura mettre en oeuvre l'invention quel que soit le circuit utilisé, adapté à déclencher les triacs de protection en cas de surtension entre deux plots quelconques du circuit.

## Revendications

1. Structure de protection d'un circuit intégré contre des décharges électrostatiques, comprenant un ensemble de cellules identiques (30a, 30b, 30c), dont chacune est reliée à une borne constituant un plot (3) du circuit, un premier rail d'alimentation (5, V_{DD}), ou un second rail d'alimentation (7, V_{SS}), les cellules formant entre deux quelconques desdites bornes un assemblage de quatre couches alternées de types de conductivité distincts (41-33-37-39), dans laquelle :
les cellules sont disposées en matrice ;
les cellules de diagonales consécutives parallèles de la matrice sont connectées entre elles ; et
les diagonales consécutives de cellules interconnectées sont reliées à des bornes constituant, dans l'ordre : le premier rail d'alimentation (5, V_{DD}), un premier plot (3), le second rail d'alimentation (7, V_{SS}), un deuxième plot, le premier rail d'alimentation (5, V_{DD}), et ainsi de suite.

2. Structure selon la revendication 1, dans laquelle les cellules (30a, 30b, 30c) sont formées dans une couche (33) d'un premier type de conductivité d'un premier niveau de dopage, chaque cellule comprenant un caisson (37a, 37b, 37c) d'un second type de conductivité d'un deuxième niveau de dopage, contenant du côté de sa surface des régions voisines (39a, 41a, 39b, 41b, 39c, 41c) de niveaux de dopage supérieurs aux premier et deuxième niveaux et de types de conductivité opposés, en contact avec une métallisation (43a, 43b, 43c) reliée à ladite borne.

3. Structure selon la revendication 2, dans laquelle des régions de contact (45) du premier type de conductivité et d'un niveau de dopage supérieur au premier niveau, sont disposées du côté de la face supérieure de ladite couche (33) et sont adaptées à recevoir un signal de déclenchement.

4. Structure selon la revendication 3, dans laquelle les régions de contact (45) sont reliées à la sortie d'un circuit de déclenchement adapté à fournir un signal de commande en cas de surtension entre deux quelconques desdites bornes.

5. Structure selon la revendication 4, dans laquelle ledit circuit de déclenchement comporte :
- un détecteur de surtension adapté à fournir un signal de sortie haut quand le circuit intégré est alimenté,
- un premier inverseur dont l'entrée (A) est reliée à la sortie du détecteur,
- un second inverseur dont l'entrée (B) est reliée à la sortie du premier inverseur, la sortie (C) du second inverseur constituant la sortie du circuit de déclenchement,
- au moins une première diode (73) connectée en direct entre la sortie (C) du second inverseur et le premier rail d'alimentation (5), et
- un thyristor (75) connecté en direct entre la sortie (C) du second inverseur et un plot (3) du circuit, les gâchettes d'anode et de cathode du thyristor étant respectivement reliées à la sortie (C) du second inverseur et au second rail d'alimentation (7).

6. Structure selon la revendication 5, dans laquelle :
- ledit détecteur est constitué d'un premier transistor MOS à canal P (61) et d'un premier transistor MOS à canal N (63), la source et le drain du premier transistor à canal P (61) étant respectivement reliés au premier rail d'alimentation (5) et à la grille du premier transistor à canal N (63), la grille du premier transistor à canal P (61) et la source et le drain du premier transistor à canal N (63) étant reliés au second rail d'alimentation (7),
- le premier inverseur est constitué d'un second transistor MOS à canal P (65) et d'un second transistor MOS à canal N (67) et est alimenté par les premier (5) et second (7) rails d'alimentation,
- le second inverseur est constitué d'un troisième transistor MOS à canal P (69) et d'un troisième transistor MOS à canal N (71) et est alimenté par les premier (5) et second (7) rails d'alimentation.

7. Structure selon l'une quelconque des revendications 1 à 6, dans laquelle chaque couple de cellules (30a, 30b, 30c) forme un triac entre deux desdites bornes.

8. Structure selon l'une quelconque des revendications 1 à 7, dans laquelle les cellules (30a, 30b, 30c) sont disposées dans une couronne située entre les plots (3) et la partie centrale (1) du circuit.

## Revendications modifiées

### Revendications modifiées conformément à la règle 137(2) CBE.

**1.** Structure de protection d'un circuit intégré contre des décharges électrostatiques, comprenant un ensemble de cellules identiques (30a, 30b, 30c), dont chacune est reliée à une borne constituant un plot (3) du circuit, un premier rail d'alimentation (5, V_{DD}), ou un second rail d'alimentation (7, V_{SS}), les cellules formant entre deux quelconques desdites bornes un assemblage de quatre couches alternées de types de conductivité distincts (41-33-37-39), dans laquelle :
les cellules sont disposées en matrice ;
les cellules d'une première diagonale de la matrice sont connectées entre elles ;
les cellules de diagonales consécutives parallèles à la première diagonale sont connectées entre elles ; et
les diagonales consécutives de cellules interconnectées sont reliées à des bornes constituant, dans l'ordre : le premier rail d'alimentation (5, V_{DD}), un premier plot (3), le second rail d'alimentation (7, V_{SS}), un deuxième plot, le premier rail d'alimentation (5, V_{DD}), et ainsi de suite pour les autres plots de la structure.

**2.** Structure selon la revendication 1, dans laquelle les cellules (30a, 30b, 30c) sont formées dans une couche (33) d'un premier type de conductivité d'un premier niveau de dopage, chaque cellule comprenant un caisson (37a, 37b, 37c) d'un second type de conductivité d'un deuxième niveau de dopage, contenant du côté de sa surface des régions voisines (39a, 41a, 39b, 41b, 39c, 41c) de niveaux de dopage supérieurs aux premier et deuxième niveaux et de types de conductivité opposés, en contact avec une métallisation (43a, 43b, 43c) reliée à ladite borne.

**3.** Structure selon la revendication 2, dans laquelle des régions de contact (45) du premier type de conductivité et d'un niveau de dopage supérieur au premier niveau, sont disposées du côté de la face supérieure de ladite couche (33) et sont adaptées à recevoir un signal de déclenchement.

**4.** Structure selon la revendication 3, dans laquelle les régions de contact (45) sont reliées à la sortie d'un circuit de déclenchement adapté à fournir un signal de commande en cas de surtension entre deux quelconques desdites bornes.

**5.** Structure selon la revendication 4, dans laquelle ledit circuit de déclenchement comporte :
- un détecteur de surtension adapté à fournir un signal de sortie haut quand le circuit intégré est alimenté,
- un premier inverseur dont l'entrée (A) est reliée à la sortie du détecteur,
- un second inverseur dont l'entrée (B) est reliée à la sortie du premier inverseur, la sortie (C) du second inverseur constituant la sortie du circuit de déclenchement,
- au moins une première diode (73) connectée en direct entre la sortie (C) du second inverseur et le premier rail d'alimentation (5), et
- un thyristor (75) connecté en direct entre la sortie (C) du second inverseur et un plot (3) du circuit, les gâchettes d'anode et de cathode du thyristor étant respectivement reliées à la sortie (C) du second inverseur et au second rail d'alimentation (7).

**6.** Structure selon la revendication 5, dans laquelle :
- ledit détecteur est constitué d'un premier transistor MOS à canal P (61) et d'un premier transistor MOS à canal N (63), la source et le drain du premier transistor à canal P (61) étant respectivement reliés au premier rail d'alimentation (5) et à la grille du premier transistor à canal N (63), la grille du premier transistor à canal P (61) et la source et le drain du premier transistor à canal N (63) étant reliés au second rail d'alimentation (7),
- le premier inverseur est constitué d'un second transistor MOS à canal P (65) et d'un second transistor MOS à canal N (67) et est alimenté par les premier (5) et second (7) rails d'alimentation,
- le second inverseur est constitué d'un troisième transistor MOS à canal P (69) et d'un troisième transistor MOS à canal N (71) et est alimenté par les premier (5) et second (7) rails d'alimentation.

**7.** Structure selon l'une quelconque des revendications 1 à 6, dans laquelle chaque couple de cellules (30a, 30b, 30c) forme un triac entre deux desdites bornes.

**8.** Structure selon l'une quelconque des revendications 1 à 7, dans laquelle les cellules (30a, 30b, 30c) sont disposées dans une couronne située entre les plots (3) et la partie centrale (1) du circuit.
